# EUROPEAN PATENT APPLICATION

(11) **EP 3 244 505 A1**
(43) Date of publication of application: **15.11.2017**
(21) Application number: 16169592.9
(22) Date of filing: 13.05.2016
(51) Int. Cl.: H02J 3/38, H02S 40/34, H01H 3/02, H01L 31/02

(54) **DEVICE FOR PHOTOVOLTAIC SYSTEM SECURITY**

(71) Applicant: Kinsbergen, Jeroen, 2640 Mortsel (BE)
(72) Inventor: Kinsbergen, Jeroen, 2640 Mortsel (BE)
(74) Representative: DenK iP

(57) **Abstract**

The present invention relates to a safety device for mounting between an inverter (2) and at least one photovoltaic panel of a photovoltaic system (1). The safety device comprises a waterproof housing (9) with
- inputs (3) for a positive and a negative connection of a DC voltage coming from at least one photovoltaic panel and corresponding outputs (3') for feeding said DC voltage to an inverter for converting said DC voltage,
- conductive bar (5) separated from said positive and negative connection of said DC voltage, when in a first position, and so placed that it can establish a short circuit between said positive and negative connection, when in a second position,
- means (6) for keeping said conductive bar in that first position, arranged for attaching a fireproof trigger mechanism (7,8) and for bringing said conductive bar from the first position into the second position by pulling said attached fireproof cable, whereby the conductive bar in said second position establishes the short circuit.

## Description

### Field of the invention

The present invention is generally related to the field of safety devices for use in photovoltaic installations.

### Background of the invention

Rooftop photovoltaic (PV) power systems, or solar panels, have in the past years gained a lot of interest as a source of renewable, clean energy.

Along with the increased popularity a growing concern of fire hazards has arisen when installing solar panels. One concern is that the panels can interfere with firefighters' access to the roof, including their ability to ventilate the building. Another concern is that the DC current running from the panels to the inverter doesn't get shut off when firefighters shut off the electricity to the house. PV panels, cabling and inverters always remain under voltage as long as there is light. Modern PV plants can have a nominal voltage as high as 1000VDC or even more. Hence, there is a risk of shock and of interference with attempts to douse the flames. In general the inverter of the plant is located near to the electrical cabinet in the house or building. This means that if there is a fire in the house during the daytime the DC voltage supply of the inverter is always there and is a hazard for anyone extinguishing the fire.

These topics have been addressed in many recent publications in magazines and newspapers, mostly after the occurrence of an incident. In some cases firefighters were forced to let a building covered with rooftop PV burn to the ground, because it was too dangerous to get on the roof and they simply had nothing at their disposal to prevent such catastrophe.

Some solutions have been proposed to reduce the hazard for firefighters. A solar panel sensor and fuse has been developed. Perched between two solar panels, the device senses when the temperature reaches a certain threshold. At that point, the fuse will break. The moment the fuses are broken due to the heat, the voltage goes down to a level that allows the use of water to extinguish the flames. The sensors/fuse product can be turned off manually as well.

Patent application EP2492967 A2 relates to a photovoltaic assembly with safeguard for fighting fire. The proposed system has electrical switching devices for separating an electrical connection between photovoltaic modules. Each switching device includes a safety fuse and a heating device that is arranged at the fuse such that the fuse is disconnected and the electrical connection is separated during heating the heating device. The modules are connected with an inverter by conductors. The heating device is connected with the conductors over connections for applying heating current to the heating device.

Hence, there is obviously a need for a safety device for use in photovoltaic systems, so that the safety of firefighters considerably increases.

### Summary of the invention

It is an object of embodiments of the present invention to provide for a safety device for use in photovoltaic systems.

The above objective is accomplished by the solution according to the present invention.

In a first aspect the invention relates to a safety device for mounting between an inverter and at least one photovoltaic panel of a photovoltaic system. The safety device comprises a waterproof housing with
- inputs for a positive and a negative connection of a DC voltage coming from at least one photovoltaic panel and corresponding outputs for feeding the DC voltage to an inverter for converting the DC voltage,
- a conductive bar separated from the positive and negative connection of the DC voltage when in a first position, and so placed that it can establish a short circuit between the positive and negative connection when in a second position,
- means for keeping the conductive bar in that first position, said means being arranged for attaching a fireproof trigger mechanism and for bringing the conductive bar from the first position into the second position by triggering the trigger mechanism, whereby the conductive bar in the second position establishes the short circuit.

The proposed solution indeed allows considerably reducing the risk for firefighters in case the photovoltaic system catches fire. In normal operation a conductive bar is kept in a first position and the positive and negative connections directly transport the DC voltage to the inverter via the outputs in the waterproof housing. A trigger mechanism, e.g. a fireproof pulling cable, is provided attached to the means that keep the conductive bar in said first position. In case of hazard the DC voltage is shorted by the conductive bar by simply triggering the trigger mechanism. In this way the conductive bar is brought into its second position where it shorts the positive and negative connection.

In one embodiment the means for keeping the conductive bar in that first position is a rod. In a preferred embodiment the trigger mechanism is a fireproof puling cable. Preferably, the rod then comprises a pinhole to attach the fireproof pulling cable.

In an embodiment the rod extends beyond the waterproof housing and the waterproof housing comprises a hole for the rod.

In a preferred embodiment the means for keeping the conductive bar in the first position is a magnet mounted on the outside of the waterproof housing.

In an embodiment the conductive bar is placed diagonally between the positive and negative connection and arranged to be triggered by pulling whereby it pivots to connect the positive and negative connection together.

For purposes of summarizing the invention and the advantages achieved over the prior art, certain objects and advantages of the invention have been described herein above. Of course, it is to be understood that not necessarily all such objects or advantages may be achieved in accordance with any particular embodiment of the invention. Thus, for example, those skilled in the art will recognize that the invention may be embodied or carried out in a manner that achieves or optimizes one advantage or group of advantages as taught herein without necessarily achieving other objects or advantages as may be taught or suggested herein.

The above and other aspects of the invention will be apparent from and elucidated with reference to the embodiment(s) described hereinafter.

### Brief description of the drawings

The invention will now be described further, by way of example, with reference to the accompanying drawings, wherein like reference numerals refer to like elements in the various figures.
Fig.1 illustrates the device according to the invention placed between a PV system and an inverter.
Fig.2 illustrates the normal operation of the device of the invention when a current flows from the PV system to the inverter.
Fig.3 illustrates an embodiment of the safety device in normal operation.
Fig.4 illustrates operation of the safety device when the trigger mechanism has been activated.

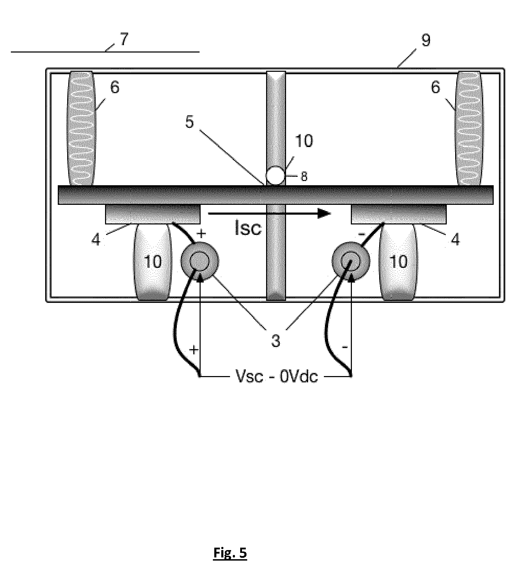

Fig.5 illustrates the same embodiment of the safety device as in Fig.3, in a situation wherein the trigger mechanism has been activated.

### Detailed description of illustrative embodiments

The present invention will be described with respect to particular embodiments and with reference to certain drawings but the invention is not limited thereto but only by the claims.

Furthermore, the terms first, second and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

It should be noted that the use of particular terminology when describing certain features or aspects of the invention should not be taken to imply that the terminology is being redefined herein to be restricted to include any specific characteristics of the features or aspects of the invention with which that terminology is associated.

In the description provided herein, numerous specific details are set forth. However, it is understood that embodiments of the invention may be practiced without these specific details. In other instances, well-known methods, structures and techniques have not been shown in detail in order not to obscure an understanding of this description.

The present invention proposes a simple but efficient solution to the above-mentioned dangers when a fire occurs where a solar plant is installed. The device according to the invention is designed to secure residential, commercial and industrial photovoltaic (PV) plants against fire, uncontrolled electrical arcing and to keep people safe while extinguishing a fire where a solar plant is installed.

Due to this device it is possible to relocate the dangerous voltages and currents to the roof close by the panels, securing the rest of the building and wires. The device is designed to short the PV cables in dangerous situations. This results in all the cables beyond the device being completely without power and secure to work on or to extinguish.

The safety device is preferably installed as close as possible to the solar panels in order to secure as much cable and building as possible. The safety device basically acts as a switch. A trigger mechanism, e.g. fireproof cable, is run in a cable gain together with the solar cables to the inverter location. In case of fire or any other dangerous situation, the cable can be pulled which trips the switch and short-circuits the cables.

In one embodiment fuses are installed to shut down the current also after tripping the switch. This makes the switch easily resettable after the issues are resolved. Without the fuses the reset can only be done when it is completely dark, as the short circuit current will be flowing continuously during daytime.

The device is obviously 100% waterproof and is mountable on the PV panel construction.

In the remainder of this description a number of embodiments of the safety device is presented more in detail.

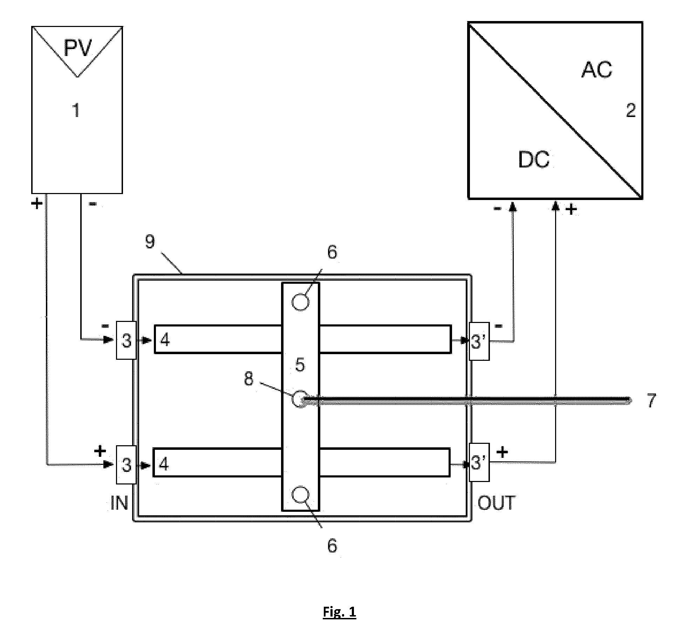

In the embodiment illustrated in Fig.1 a PV string 1 (i.e. a series connection of PV panels) is shown from which a positive and negative pole of the DC voltage is applied to connectors at the input 3 of the safety device. The DC voltage is guided through the device by means of e.g. a copper or aluminium bar 4. Via output connectors 3' the DC voltage is then fed to a solar inverter 2. In this inverter the DC voltage is converted, e.g. into an AC voltage. Another conductive bar 5 is kept in a position separated from the bars connecting the input and output for the positive and negative pole of the DC voltage, respectively. When an attached fireproof cable 7 is pulled, this conductive bar is brought into a position whereby a short circuit is created.

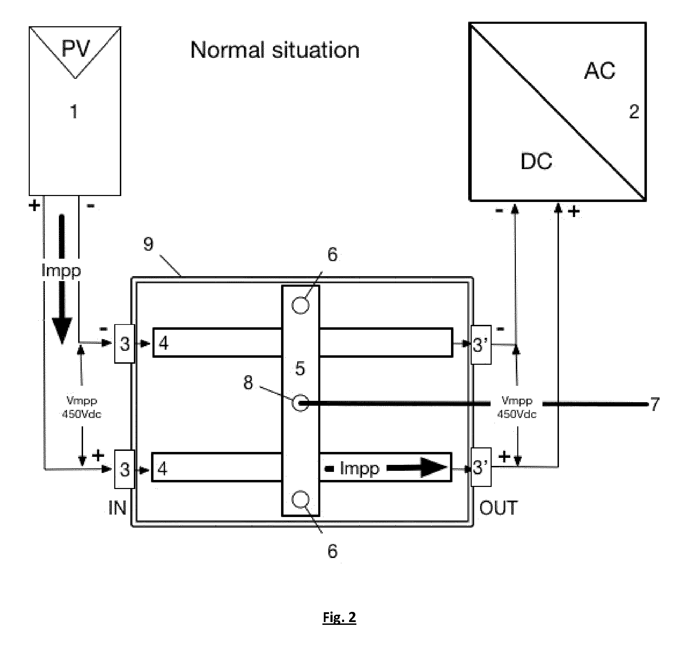

The normal way of operation is illustrated in Fig.2. A DC voltage of e.g. 450 V at maximum power point (Vmpp) passes via the safety device according to the invention from the solar plant 1 to the inverter 2. In the embodiment of Fig.2 the inverter is arranged for converting the DC voltage into an AC voltage. A corresponding current at maximum power point (Impp) runs via the connection 4 to the outputs 3'. The figure then shows the 450 VDC being applied to the inverter 2. The trigger mechanism including in this embodiment a pinhole 8 and a pulling cable 7, remains in a rest position, i.e. the conductive bar 5 is kept fixed in its first position separated from the connections guiding the DC voltage through the safety device.

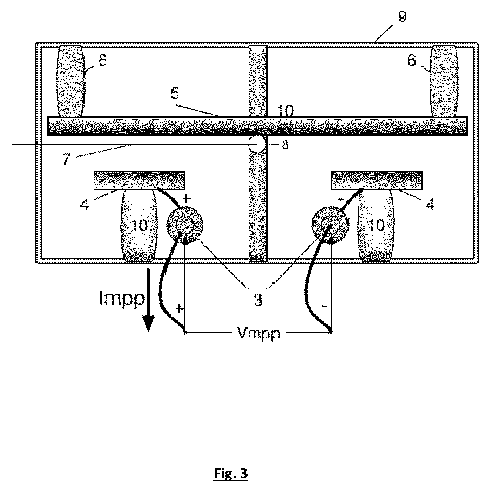

Several options are available for keeping the conductive bar 5 in its first position. In the embodiment shown in Fig.3 the conductive bar 5 is kept in place by resilient means 6 (e.g. wire springs) attaching the conductive bar 5 to the housing 9 by means of an insulating support 10. The conductive bar 5 may comprise a pinhole 8 via which the fireproof pulling cable 7 is attached. The conductive bar is released by pulling the fireproof cable, whereby a short circuit is established.

In one embodiment a magnet is used placed on the outside of the waterproof housing. If in case of emergency the cable is pulled, the magnet releases the bar and trips the mechanism to create the short circuit.

Another way to implement the means for keeping the conductive bar 5 in its first position, is as a small rod provided with a pinhole.

When the short circuiting conductive bar 5 is diagonally positioned and secured in an appropriate way, it can be pivoted between the positive and negative guiding connections. The bar can be pulled so that it pivots to a position wherein it secures the short circuit between the positive and negative bars that guide the DC voltage.

A cost saving alternative can be to run the solar cables through the housing and secure them in the same position as the conductive positive and negative bar. By implementing the short circuit conductive bar 5 as a conducting blade, the cable insulation is cut when tripping the mechanism and the short circuit is established through the blade.

Although in the embodiments presented above a fireproof pulling cable was used as mechanism to trigger the switching from the first to the second position of the conductive bar, other options can readily be considered by the skilled person. For example, in one embodiment a more advanced system with remote control can be envisaged e.g. using a wireless remote control for triggering an electronic switch to release the conductive bar mechanism.

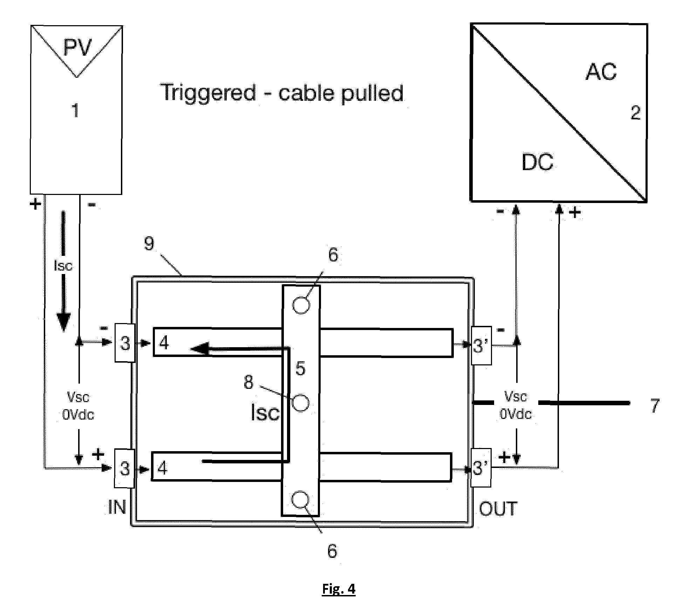

Turning back now to the embodiment with a fireproof pulling cable, Fig.4 illustrates a situation after the fireproof cable has been pulled to release the pin 7 and activate the trigger mechanism. A short circuit is created by means of the conductive bar 5, which is pushed on top of the power bars 4. The flow direction of the short circuit current Isc is indicated. In this way all voltages are taken away from the cables at the output.

With additional fuses installed at the input 3 configured just underneath the Isc (Short Circuit Current) of the PV string these will trip and secure the box and the rest of the PV system.

Resetting the safety device after use in its normal condition of Fig.2, needs to be performed at night time when no solar energy can be produced.

While the invention has been illustrated and described in detail in the drawings and foregoing description, such illustration and description are to be considered illustrative or exemplary and not restrictive. The foregoing description details certain embodiments of the invention. It will be appreciated, however, that no matter how detailed the foregoing appears in text, the invention may be practiced in many ways. The invention is not limited to the disclosed embodiments.

Other variations to the disclosed embodiments can be understood and effected by those skilled in the art in practicing the claimed invention, from a study of the drawings, the disclosure and the appended claims. In the claims, the word "comprising" does not exclude other elements or steps, and the indefinite article "a" or "an" does not exclude a plurality. A single processor or other unit may fulfil the functions of several items recited in the claims. The mere fact that certain measures are recited in mutually different dependent claims does not indicate that a combination of these measures cannot be used to advantage. A computer program may be stored/distributed on a suitable medium, such as an optical storage medium or a solid-state medium supplied together with or as part of other hardware, but may also be distributed in other forms, such as via the Internet or other wired or wireless telecommunication systems. Any reference signs in the claims should not be construed as limiting the scope.

## Claims

1. Safety device for mounting between an inverter (2) and at least one photovoltaic panel (1) of a photovoltaic system, said safety device comprising a waterproof housing (9) with
- inputs (3) for a positive and a negative connection of a DC voltage coming from at least one photovoltaic panel and corresponding outputs (3') for feeding said DC voltage to an inverter for converting said DC voltage,
- a conductive bar (5) separated from said positive and negative connection of said DC voltage, when in a first position, and so placed that it can establish a short circuit between said positive and negative connection, when in a second position,
- means (6) for keeping said conductive bar in said first position, said means arranged for attaching a fireproof trigger mechanism (7,8) and for bringing said conductive bar from said first position into said second position by triggering said attached trigger mechanism, whereby said conductive bar in said second position establishes said short circuit.

2. Safety device as in claim 1, wherein said means (6) for keeping said conductive bar in said first position is a rod.

3. Safety device as in any of the previous claims, wherein said fireproof trigger mechanism is a fireproof pulling cable.

4. Safety device as in claim 3, wherein said rod comprises a pinhole to attach said fireproof pulling cable.

5. Safety device as in any of claims 2 to 4, wherein said rod extends beyond said waterproof housing and said waterproof housing comprises a hole for said rod.

6. Safety device as in claim 1, wherein said means (6) for keeping said conductive bar in said first position is a magnet mounted on the outside of said waterproof housing.

7. Safety device as in any of the previous claims, wherein said conductive bar (1) is attached to said waterproof housing via resilient means (6).

8. Safety device as in any of the previous claims, wherein said conductive bar is placed diagonally between the positive and negative connection and arranged to be triggered by pulling whereby said conductive bar pivots to connect said positive and negative connection together.
